(19) Europäisches Patentamt
European Patent Office
Office européen des brevets

(11) **EP 3 279 653 A1**

(12) **EUROPÄISCHE PATENTANMELDUNG**

(43) Veröffentlichungstag:
**07.02.2018 Patentblatt 2018/06**

(51) Int Cl.:
**G01N 27/72** *(2006.01)*  **G01R 33/04** *(2006.01)*

(21) Anmeldenummer: **16182466.9**

(22) Anmeldetag: **02.08.2016**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**MA MD**

(71) Anmelder: **voestalpine Stahl GmbH**
**4020 Linz (AT)**

(72) Erfinder:
• **Schuster, Stefan**
**4470 Enns (AT)**
• **Gstöttenbauer, Norbert**
**4209 Engerwitzdorf (AT)**
• **Thaler, Christoph**
**4020 Linz (AT)**
• **Wöckinger, Daniel**
**4209 Engerwitzdorf (AT)**

(74) Vertreter: **Jell, Friedrich**
**Bismarckstrasse 9**
**4020 Linz (AT)**

(54) **VORRICHTUNG UND VERFAHREN ZUR ZERSTÖRUNGSFREIEN GEHALTSBESTIMMUNG DES MAGNETISIERBAREN UND/ODER NICHT-MAGNETISIERBAREN ANTEILS EINER PROBE**

(57)     Es wird eine Vorrichtung (100, 101, 102) und ein Verfahren zur zerstörungsfreien Gehaltsbestimmung des magnetisierbaren und/oder nicht-magnetisierbaren Anteils einer Probe (1) gezeigt, bei dem in einem Luftspalt (2, 12) eines magnetisch leitenden Jochs (3, 30) die Probe (1) vorgesehen wird, durch eine magnetische Wechselfeldstärke (H) einer Erregerspule (4) im Joch (3, 30) ein magnetisches Wechselfeld (B) erzeugt und mit mindestens einer induktiv mit dem Joch (3, 30) gekoppelten Messeinrichtung (5) erste Messdaten ($M_p$) der Probe (1) erfasst werden, und mit Hilfe eines Vergleichs der ersten Messdaten ($M_p$) mit zweiten Messdaten ($M_{ref}$) von einer Referenzprobe (6), mit bekanntem magnetisierbarem und/oder nichtmagnetisierbarem Gehaltsanteil, der magnetisierbare und/oder nichtmagnetisierbare Gehaltsanteil in der Probe (1) bestimmt wird. Um das Verfahren zuverlässiger zu gestalten, wird vorgeschlagen, dass bei der Erfassung der ersten und zweiten Messdaten ($M_p$, $M_{ref}$) der Probe (1) und Referenzprobe (6) mit Hilfe der Erregerspule (4) die gleiche magnetische Wechselfeldstärke (H) oder das gleiche magnetische Wechselfeld (B) sowohl in die Referenzprobe (6) als auch in die Probe (1) eingeprägt wird, und die Differenz der beiden erfassten Messdaten ($M_{ref}$, $M_p$) als Maß in die Gehaltsbestimmung für den magnetisierbaren und/oder nicht-magnetisierbaren Gehaltsanteil der Probe (1) eingeht.

Fig. 1

EP 3 279 653 A1

## Beschreibung

Die Erfindung betrifft ein Verfahren zur zerstörungsfreien Gehaltsbestimmung des magnetisierbaren und/oder nicht-magnetisierbaren Anteils einer Probe, bei dem in einem Luftspalt eines magnetisch leitenden Jochs die Probe vorgesehen wird, durch eine magnetische Wechselfeldstärke einer Erregerspule im Joch ein magnetisches Wechselfeld erzeugt und mit mindestens einer induktiv mit dem Joch gekoppelten Messeinrichtung erste Messdaten der Probe erfasst werden, und mit Hilfe eines Vergleichs der ersten Messdaten mit zweiten Messdaten von einer Referenzprobe, mit bekanntem magnetisierbarem und/oder nicht-magnetisierbarem Gehaltsanteil, der magnetisierbare und/oder nicht-magnetisierbare Gehaltsanteil in der Probe bestimmt wird.

Aus dem Stand der Technik sind zerstörungsfreie Verfahren bekannt (EP0267896A2), mit denen der magnetisierbare und nicht-magnetisierbare bzw. ferromagnetische Gehaltsanteil einer Probe bestimmt werden kann. Dabei wird die zu messende Probe in einem Luftspalt eines magnetisch leitenden Jochs vorgesehen, das über eine Erregerspule mit einer bestimmten magnetischen Feldstärke beaufschlagt wird. Die Erregerspule ist Teil eines elektrischen Schwingkreises, dessen Resonanzfrequenz sich in Abhängigkeit des magnetisierbaren bzw. nicht-magnetisierbaren Anteils der Proben verändert. Mit einer Messeinrichtung wird bei einer Messfrequenz von diesem Schwingkreis ein Messstrom abgegriffen und dazu verwendet, auf den Gehalt an magnetisierbaren bzw. nicht-magnetisierbaren Anteil in der Probe rückzuschließen. Ein derartiges Verfahren ist jedoch vergleichsweise störanfällig und erfordert zudem ein komplexes Auswerteverfahren - insbesondere, weil die magnetische Permeabilität $\mu$ einen nicht-linearen Verlauf aufweist.

Die Erfindung hat sich daher die Aufgabe gestellt, ein Verfahren der eingangs erwähnten Art derart zu verbessern, dass dieses schneller durchzuführen ist und dennoch eine hohe Zuverlässigkeit aufweist.

Die Erfindung löst die gestellte Aufgabe hinsichtlich des Verfahrens dadurch, dass bei der Erfassung der ersten und zweiten Messdaten der Probe und Referenzprobe mit Hilfe der Erregerspule die gleiche magnetische Wechselfeldstärke oder das gleiche magnetische Wechselfeld sowohl in die Referenzprobe als auch in die Probe eingeprägt wird, und die Differenz der beiden erfassten Messdaten als Maß in die Gehaltsbestimmung für den magnetisierbaren und/oder nicht-magnetisierbaren Gehaltsanteil der Probe eingeht.

Wird bei der Erfassung der ersten und zweiten Messdaten der Probe und Referenzprobe mit Hilfe der Erregerspule die gleiche magnetische Wechselfeldstärke oder das gleiche magnetische Wechselfeld sowohl in die Referenzprobe als auch in die Probe eingeprägt, so können trotz der nicht-linearen magnetischen Permeabilität $\mu$ bzw. deren Funktions-Abhängigkeit vom magnetisierbaren und/oder nicht-magnetisierbaren Gehaltsanteil vergleichbare Messdaten von Probe und Referenzprobe gewonnen werden.

Dies kann beispielsweise in einer ersten Variante durch das Einprägen einer magnetischen Wechselfeldstärke mit identischem zeitlichem Signalverlauf (Frequenz und Amplitude) sowohl in die Probe als auch in die Referenzprobe (etwa durch Regelung des Stroms i(t) der Erregerspule) erzielt werden. Dabei kann - unter Annahme einer (im Messbereich) konstanten Permeabilität des Jochs $\mu_J$ - auch dessen magnetischer Widerstand $R_J$ als konstant angenommen werden. Die magnetischen Widerstände der Referenzprobe $R_{ref}$ und der Probe $R_p$ können damit als Funktionen der magnetischen Durchflutung $\Theta_E$ (erzeugt durch die Erregerspule) und des magnetischen Flusses $\Phi_{ref}$ in der Referenzprobe bzw. des magnetischen Flusses $\Phi_p$ in der Probe ausgedrückt werden:

$$R_{\mathrm{ref}} = \frac{\Theta_{\mathrm{E}}(t)}{\Phi_{\mathrm{ref}}(t)} - R_J \qquad\qquad (1)$$

$$R_{\mathrm{p}} = \frac{\Theta_{\mathrm{E}}(t)}{\Phi_{\mathrm{p}}(t)} - R_J \qquad\qquad (2)$$

In einer zweiten Variante kann durch Einprägen eines gleichen magnetischen Wechselfelds B erreicht werden, dass zu jedem Zeitpunkt der gleiche magnetische Fluss $\Phi_p$ bzw. $\Phi_{ref}$ durch die Probe, die Referenzprobe und das Joch fließt ($\Phi_{ref} = \Phi_p$). Die magnetischen Widerstände der Referenzprobe $R_{ref}$ und der Probe $R_p$ können damit wiederum als Funktionen des magnetischen Flusses $\Phi_p$ bzw. $\Phi_{ref}$ ausgedrückt werden:

$$R_{\mathrm{ref}} = \frac{\Theta_{\mathrm{E}}(t)}{\Phi_{\mathrm{ref}}(t)} - R_J(\Phi_{\mathrm{ref}}(t)) \qquad\qquad (3)$$

$$R_{\mathrm{p}} = \frac{\Theta_{\mathrm{E}}(t)}{\Phi_{\mathrm{p}}(t)} - R_J(\Phi_{\mathrm{ref}}(t)) \qquad\qquad (4)$$

2

Beide Varianten führen erfindungsgemäß nun dazu, dass der Einfluss des Jochs aus den Messungen eliminierbar ist. Sohin ist es auch in weiterer Folge möglich, eine Differenz der beiden erfassten Messdaten zu bilden und dies als Maß in die Gehaltsbestimmung für den magnetisierbaren und/oder nicht-magnetisierbaren Gehaltsanteil der Probe eingehen zu lassen.

Durch Messung des magnetischen Flusses der Referenzprobe $\Phi_{ref}$ und der Probe $\Phi_p$, kann nämlich der magnetisierbare Gehaltsanteil der Probe - bei bekanntem magnetisierbarem Gehaltsanteil der Referenzprobe - aus dem Verhältnis der magnetischen Widerstände $R_{ref}$ und $R_p$ bestimmt werden (durch Subtraktion und Umformung der Gleichungen (2)-(1) bzw. (4)-(3)). Damit ist ein einfaches Auswerteverfahren zum Vergleich der Messdaten von Probe und Referenzprobe geschaffen, welches unter anderem durch seine Einfachheit in der Berechnung eine zuverlässigere und zugleich schnellere Bestimmung des magnetisierbaren bzw. nicht-magnetisierbaren Gehaltsanteils einer Probe ermöglichen kann.

Werden die magnetischen Wechselfelder (B) über eine induktiv über das Joch mit der Erregerspule gekoppelten Messeinrichtung gemessen, so kann eine direkte Bestimmung der magnetischen Flussdichte im Joch ermöglicht werden. Insbesondere bevorzugt ist die Messeinrichtung hierbei als Messspule über dem Joch ausgeführt. Dabei wird die in der Messspule induzierte Spannung V(t) durch einen Integrator aufintegriert, um die Magnetfeldstärke (B) zu bestimmen. Ein einfaches und zugleich zuverlässiges Verfahren kann somit geschaffen werden.

Werden bei der Gehaltsbestimmung des magnetisierbaren und/oder nicht-magnetisierbaren Gehaltsanteils in der Probe die relative Permeabilität der Probe und der Referenzprobe bestimmt, so ist ein physikalisch aufschlussreicher Parameter, welcher den magnetisierbaren Gehalt der Probe wiederspiegelt, bestimmbar. Ein zuverlässiges Verfahren kann somit geschaffen werden.

Um besonders einfach aus den Differenzdaten auf den Eisengehalt rückschließen zu können, kann vorteilhaft sein, wenn die relative Permeabilität der Probe als Summe der relativen Permeabilitäten von reinem Eisen und von Luft modelliert wird. In anderen Worten, der magnetische Widerstand der Probe als auch der Referenzprobe kann als eine Serienschaltung einer Schicht mit 100% Eisengehalt und einer Schicht Luft (mit 0% Eisengehalt) modelliert werden. Dadurch kann sich ein einfacher Zusammenhang zwischen Messdaten/Differenzdaten und Eisengehalt ergeben, was nicht nur ein schnelles sondern auch ein zuverlässiges Verfahren ermöglichen kann. Im Allgemeinen wird erwähnt, dass sich als vorteilhaft erweisen kann, wenn der magnetisierbare Anteil der Referenzprobe ähnlich hoch ist wie der magnetisierbare Anteil der zu vermessenden Probe, um damit die Empfindlichkeit/Messgenauigkeit der Vorrichtung zu erhöhen. Vorzugsweise ist der magnetisierbare Anteil der Referenzprobe der Mittelwert aus den zu erwartenden magnetisierbaren Anteilen der zu bestimmenden Proben.

Verfahrenstechnisch einfach lässt sich das Verfahren realisieren, wenn die gleiche magnetische Wechselfeldstärke durch Regelung des Spulenstroms i(t) der Erregerspule in Probe und Referenzprobe eingeprägt wird. So kann etwa ein in Frequenz und Amplitude gleicher Strom i(t) durch die Erregerspule laufen und in dieser eine definierte magnetische Wechselfeldstärke induzieren. Zu diesem Zweck kann beispielsweise eine Stromregeleinrichtung in dem Verfahren angeordnet sein, um der Spule einen definierten Strom i(t) einzuprägen.

Alternativ kann sich ein zuverlässiges Verfahren ergeben, wenn das gleiche magnetische Wechselfeld durch dessen Regelung in Probe und Referenzprobe eingeprägt wird. Dies kann vorzugsweise durch Messung des magnetischen Wechselfelds in einer Messspule erfolgen, wobei die induzierte Spannung in der Messspule einem Integrator zugeführt wird, welcher wiederum mit einem Regler verbunden ist, um so das magnetische Wechselfeld im Joch zu regeln.

Liegt zudem der Arbeitspunkt der Wechselfeldstärke bei der Messdatenerfassung im Bereich des flachen Kurvenverlaufs der magnetischen Permeabilität des Jochs, so kann ein besonders zuverlässiges Verfahren geschaffen werden. Insbesondere kann dabei der Näherungsfehler bei Annahme einer konstanten Permeabilität des Jochs weiter reduziert werden.

Die Erfindung hat sich zudem die Aufgabe gestellt, eine Vorrichtung zur schnellen und zuverlässigen Durchführung des erfindungsgemäßen Verfahrens zu schaffen. Zudem soll die Vorrichtung den magnetisierbaren und/oder nicht-magnetisierbaren Gehaltsanteil der Probe besonders exakt bestimmen können.

Die Erfindung löst die gestellte Aufgabe durch eine Vorrichtung nach einem der Ansprüche 8 bis 11.

Indem die Vorrichtung eine mit dem Joch induktiv gekoppelte erste Messspule aufweist, von der die Messeinrichtung Messdaten erfasst, und indem die Vorrichtung mit der Erregerspule zusammenwirkende Regeleinrichtung zur Einprägung der gleichen magnetischen Wechselfeldstärke oder des gleichen magnetischen Wechselfelds im ersten Luftspalt für die Referenzprobe oder die Probe aufweist, und indem die Vorrichtung eine Differenzschaltung aufweist, die zur Erzeugung von Differenzdaten aus den Messdaten von Referenzprobe und Probe ausgebildet ist, und in dem die Vorrichtung eine mit einer mit der Differenzschaltung verbundenen Auswerteeinrichtung aufweist, die zur Gehaltsbestimmung für den magnetisierbaren und/oder nicht-magnetisierbaren Gehaltsanteil in der Probe in Abhängigkeit der Differenzdaten ausgebildet ist, kann auf konstruktive Weise sichergestellt werden, dass die von Probe und Referenzprobe erfassten Messdaten vergleichbar sind - und damit der magnetisierbare und/oder nicht-magnetisierbare Gehaltsanteil der Probe exakt bestimmt werden kann.

Zum Einprägen einer gleichen magnetischen Wechselfeldstärke in Probe und Referenzprobe ist auch alternativ eine Vorrichtung mit einem ersten magnetisch leitenden Joch, das einen ersten Luftspalt zur Aufnahme der Probe aufweist, mit einer mit dem ersten Joch induktiv gekoppelten ersten Messspule, mit einem zweiten magnetisch leitenden Joch, das einen zweiten Luftspalt zur Aufnahme einer Referenzprobe aufweist, mit einer mit dem zweiten Joch induktiv gekoppelten zweiten Messspule und mit einer Erregerspule, die mit den beiden Jochen induktiv gekoppelt ist, vorstellbar. Die Bestimmung des Gehalts kann mit einer Messeinrichtung, die erste und zweite Messdaten von der ersten und zweiten Messspule erfasst, mit einer mit der Messeinrichtung verbundenen Differenzschaltung, die zur Erzeugung von Differenzdaten aus den Messdaten von Referenzprobe und Probe ausgebildet ist, und mit einer mit der Differenzschaltung verbundenen Auswerteeinrichtung, die zur Gehaltsbestimmung für den magnetisierbaren und/oder nicht-magnetisierbaren Gehaltsanteil in der Probe in Abhängigkeit der Differenzdaten ausgebildet ist, vorgenommen werden.

Alternativ ist auch eine Vorrichtung mit einem magnetisch leitenden Joch, das einen Mittelsteg und zwei daran anschließende seitliche Schenkel mit je einem Luftspalt aufweist, wobei der erste Luftspalt zum Einsetzen einer einen ferromagnetischen Materialanteil aufweisenden Referenz und der zweite Luftspalt zum Einsetzen der Probe ausgebildet ist, mit mindestens einer am Mittelsteg des Jochs vorgesehenen Erregerspule und mit wenigstens einer an jedem Schenkel vorgesehenen ersten und zweiten Messspule vorstellbar, die mit der zugehörigen Erregerspule über das Joch induktiv gekoppelt sind. Damit kann - konstruktiv einfach gelöst - sichergestellt werden, dass in die Probe und Referenzprobe die gleiche magnetische Wechselfeldstärke einprägt wird. Sohin kann die Differenzbildung der Messdaten von Probe und Referenzprobe erfolgen, nämlich mit einer Messeinrichtung, die erste und zweite Messdaten der ersten und zweiten Messspule erfasst, und mit einer mit der Messeinrichtung verbundenen Differenzschaltung, die zur Erzeugung von Differenzdaten aus den Messdaten von Referenzprobe und Probe ausgebildet ist. Konstruktiv einfach gelöst kann nun mit einer mit der Differenzschaltung verbundenen Auswerteeinrichtung, die zur Gehaltsbestimmung für den magnetisierbaren und/oder nicht-magnetisierbaren Gehaltsanteil in der Probe in Abhängigkeit der Differenzdaten ausgebildet ist, die Probe anhand der Referenzprobe genau und zerstörungsfrei analysiert werden.

Die Vorrichtung kann konstruktiv weiter vereinfacht werden, wenn die Differenzschaltung zur Erzeugung von Differenzdaten beide Messspulen elektrisch in Serie schaltet.

In den Figuren ist beispielsweise der Erfindungsgegenstand anhand einer Ausführungsvariante näher dargestellt. Es zeigen

Fig. 1 eine Vorrichtung zur Durchführung des erfindungsgemäßen Verfahrens,
Fig. 2 eine grafische Darstellung der Magnetisierungskurven im Messverfahren,
Fig. 3 eine weitere Vorrichtung zur Durchführung des erfindungsgemäßen Verfahrens und
Fig. 4 eine dritte Vorrichtung zur Durchführung des erfindungsgemäßen Verfahrens.

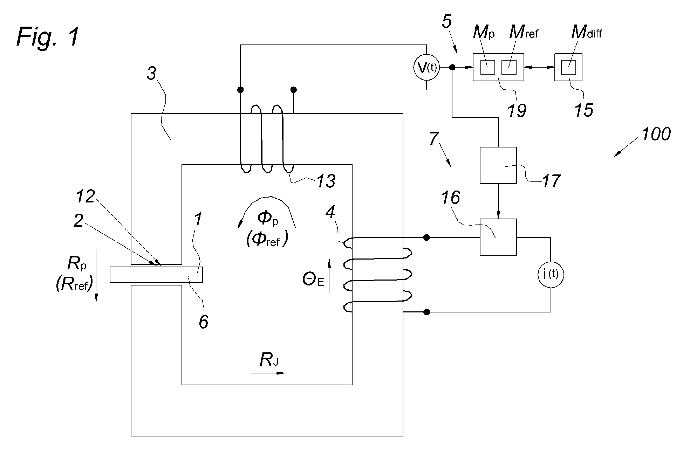

In Fig. 1 ist eine Vorrichtung 100 zur Durchführung des erfindungsgemäßen Verfahrens zur zerstörungsfreien Gehaltsbestimmung des magnetisierbaren bzw. nicht-magnetisierbaren Anteils einer Probe 1 dargestellt.

Die Probe 1 wird dabei in einen Luftspalt 2 eines magnetisch leitenden Jochs 3 eingebracht. Über die Erregerspule 4 wird das Joch 3 mit einer magnetischen Feldstärke H beaufschlagt, welches eine magnetische Durchflutung $\Theta_E$ in der Spule induziert und im Joch 3 - und damit auch in der Probe 1 - ein magnetisches Wechselfeld B, bzw. ein magnetischer Fluss $\Phi_{ref}$ bzw. $\Phi_p$ erzeugt.

Eine Messeinrichtung 5 wiederum ist mit dem Joch 3 induktiv gekoppelt und ist somit in der Lage, Messdaten $M_p$ der Probe 1 zu erfassen. Derart erfasste erste Messdaten $M_p$ der Probe 1 werden danach mit zweiten Messdaten $M_{ref}$ von einer Referenzprobe 6 verglichen, die mit derselben Vorrichtung 1 gemessen werden. Zudem ist von der Referenzprobe 6 der magnetisierbare bzw. nicht-magnetisierbare Gehaltsanteil bekannt.

Um nun vergleichbare Messdaten $M_p$, $M_{ref}$ zwischen Referenzprobe 6 und Probe 1 zu schaffen, wird erfindungsgemäß vorgeschlagen, stets die gleiche magnetische Wechselfeldstärke H in Probe 1 und Referenzprobe 6 einzuprägen. Hierzu ist ein Regelkreis 7 vorgesehen, der einen Stromregler 16 aufweist und damit einen Wechselstrom i(t) derart einprägt, dass Probe 1 und Referenzprobe 6 mit der gleiche magnetischen Wechselfeldstärke H belastet werden.

Alternativ kann mit Hilfe des Regelkreises 7 auch das gleiche magnetische Wechselfeld B in Probe 1 und Referenzprobe 6 eingeprägt werden, was in Fig. 1 strichliert eingezeichnet ist. Um dies zu erreichen, wird die induzierte Spannung V(t) in einer Messspule 13 gemessen und einem Integrator 17 zugeführt, welcher das Wechselfeld B errechnet. Das Ergebnis des Integrators 17 wird nun wieder dem Stromregler 16 zugeführt, welcher dafür sorgt, dass das gewünschte magnetische Wechselfeld im Joch 3 herrscht.

Erfindungsgemäß wird somit die gleiche magnetische Wechselfeldstärke H jeweils auf Probe 1 und Referenzprobe 6 eingeprägt, wobei über die Messeinrichtung 5 die magnetischen Wechselfelder B gemessen werden. Hierzu wird der jeweils komplementäre Wert (B bzw. H) von der Messeinrichtung 5 erfasst und die erfassten Messdaten $M_p$, $M_{ref}$ einer Differenzschaltung 19 zugeführt - und dort zur Differenzberechnung gespeichert. Zur Bestimmung des magnetisierbaren bzw. nicht-magnetisierbaren Gehaltsanteils in der Probe 1 wird schließlich von der Differenzschaltung 19 die Differenz dieser hintereinander gemessenen Messdaten $M_p$, $M_{ref}$ gebildet bzw. werden Differenzdaten $M_{diff}$ gebildet - und der Auswerteeinrichtung 15 zugeführt, welche diese Differenzdaten $M_{diff}$ als Maß bei der Gehaltsbestimmung für den magnetisierbaren und/oder nicht-magnetisierbaren Gehaltsanteil der Probe 1 verwendet. In anderen Worten, kann aus der Differenz der magnetischen Wechselfelder $B_{ref}$ und $B_p$ auf den Gehaltsanteil an magnetisierbarem bzw. nicht-magnetisierbarem Material in der Probe rückgeschlossen werden.

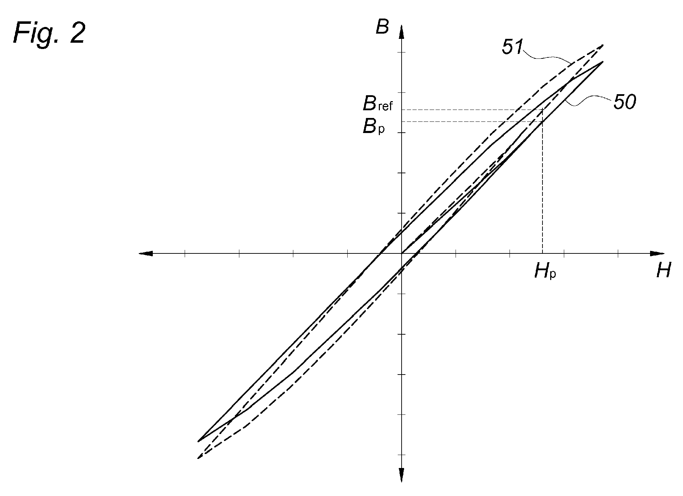

Das Ergebnis einer solchen Messung ist in Fig. 2 dargestellt. Hierbei wurden jeweils in Probe 1 und Referenzprobe 6 identische Wechselfeldstärken H eingeprägt und eine Hystereseschleife 50 der Probe als auch eine Hystereseschleife 51 der Referenzprobe über die Messeinrichtung 5 aufgezeichnet. Beide Hystereseschleifen 50, 51 können nun zu einem Punkt $H_p$ identischer Feldstärken unterschiedliche Magnetfelder $B_p$ und $B_{ref}$ aufweisen. Aus der Differenz der Magnetfeldstärken kann nun beispielsweise auf den Gehaltsanteil an magnetisierbarem Material in der Probe 1 rückgeschlossen werden - da der Gehaltsanteil an magnetisierbarem Material in der Referenzprobe 6 bekannt ist. Die äquivalente Überlegung kann für den nicht-magnetisierbaren Gehaltsanteil durchgeführt werden. Als besonders vorteilhaft kann sich dabei herausstellen, wenn die Messdaten $M_{ref}$, $M_p$ im flachen Bereich der magnetischen Permeabilität $\mu_J$ des Jochs aufgezeichnet und zur Auswertung herangezogen werden, da diese dann als nahezu konstant angenommen werden kann und somit aus der Differenzberechnung der Magnetfelder herausfällt. Aus der Differenz der Magnetfeldstärken ist somit auf die Änderung der relativen Permeabilität $\mu_r$ zwischen Probe und Referenzprobe schließbar.

Alternativ ist es jedoch ebenso möglich, bei der Messdatenerfassung identische magnetische Wechselfelder B in die Probe 1 bzw. Referenzprobe 6 einzuprägen.

Die Messeinrichtung 5 erfasst demgemäß die Feldstärken H bei jeweils gleichem Magnetfeld B in Probe 1 und Referenzprobe 6. Exemplarische Messdaten $M_{ref}$, $M_p$ zu diesem Verfahrensschritt wurden in den Figuren jedoch nicht dargestellt.

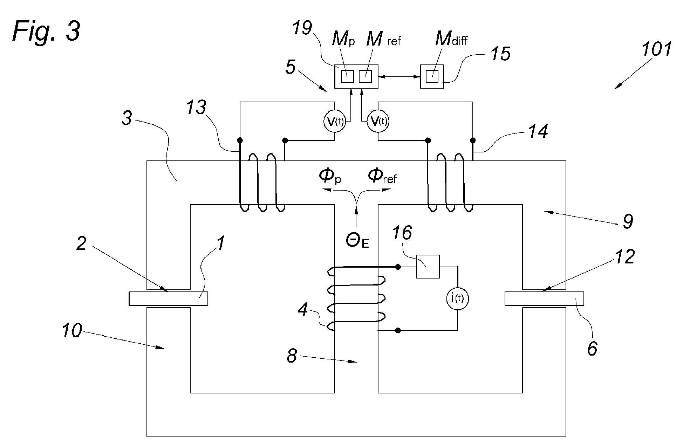

Fig. 3 zeigt eine alternative Vorrichtung 101 zur Durchführung des Messverfahrens, mit einem magnetisch leitenden Joch 3, welches einen Mittelsteg 8 und zwei daran anschließende seitliche Schenkel 9, 10 aufweist. Beide Schenkel 9, 10 zeigen jeweils einen Luftspalt 2, 12 - wobei der erste Luftspalt 2 zum Einsetzen der Probe 1 und der zweite Luftspalt 12 zum Einsetzen einer Referenzprobe 6 ausgebildet ist. Der magnetisierbare Gehaltanteil der Referenzprobe 6 ist dabei bekannt. Am Mittelsteg 8 des Jochs 3 ist eine Erregerspule 4 vorgesehen, während an beiden Schenkeln 9, 10 eine erste und zweite Messspule 13, 14 vorgesehen sind, welche mit dem Joch 3 induktiv gekoppelt sind. Eine Messeinrichtung 5 erfasst dabei erste Messdaten von der ersten Messspule 13 - also von der Probe 1 - und zweite Messdaten von der zweiten Messspule 14 - also von der Referenzprobe 6.

Die Messeinrichtung 5 erzeugt Differenzdaten $M_{diff}$ aus den ersten und zweiten Messdaten und ist wiederum mit einer Auswerteeinrichtung 15 verbunden, welche die Differenzdaten $M_{diff}$ zu Bestimmung des magnetisierbaren bzw. nicht-magnetisierbaren Gehaltsanteils heranzieht.

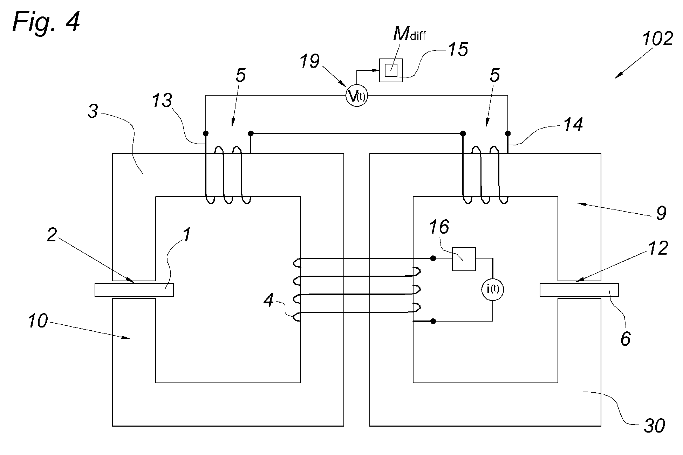

Die Messspulen 13, 14 der Messeinrichtung 5 können in einer anderen Ausführungsform aber auch in Serie geschaltet werden, wie dies beispielsweise zur Vorrichtung 102 nach Fig. 4 dargestellt ist. Aufgrund dieser Verschaltung kann durch Subtraktion der Induktionsspannungen V(t) in den Messspulen 13, 14 gleichzeitig auch eine konstruktiv einfache Differenzschaltung 19 ausgebildet werden. Zudem unterscheidet sich die nach Fig. 4 dargestellte Vorrichtung 102 von jener nach Fig. 3 dargestellten dadurch, dass in Fig. 3 nicht ein einzelnes Joch 3, sondern zwei Joche 3, 30 vorgesehen sind. Diese Joche 3, 30 weisen je eine Messspule 13, 14 und je einen Luftspalt 2, 12 auf. Zur Einprägung derselben magnetischen Wechselfeldstärke in beiden Jochen 3, 30 ist erfindungsgemäß vorgesehen, die Erregerspule 4 mit den beiden Jochen 3, 30 induktiv zu koppeln - siehe Fig. 4. Diese Bauform der Vorrichtung 102 eröffnet die Option, ein Joch 3, 30 zu wechseln, was die Vorrichtung 102 wartungsfreundlicher macht.

## Patentansprüche

1. Verfahren zur zerstörungsfreien Gehaltsbestimmung des magnetisierbaren und/oder nicht-magnetisierbaren Anteils einer Probe (1), bei dem in einem Luftspalt (2, 12) eines magnetisch leitenden Jochs (3, 30) die Probe (1) vorgesehen wird, durch eine magnetische Wechselfeldstärke (H) einer Erregerspule (4) im Joch (3, 30) ein magnetisches Wechselfeld (B) erzeugt und mit mindestens einer induktiv mit dem Joch (3, 30) gekoppelten Messeinrichtung (5) erste Messdaten ($M_p$) der Probe (1) erfasst werden, und mit Hilfe eines Vergleichs der ersten Messdaten ($M_p$) mit zweiten Messdaten ($M_{ref}$) von einer Referenzprobe (6), mit bekanntem magnetisierbarem und/oder nicht-magnetisierbarem Gehaltsanteil, der magnetisierbare und/oder nicht-magnetisierbare Gehaltsanteil in der Probe (1) bestimmt wird, **dadurch gekennzeichnet, dass** bei der Erfassung der ersten und zweiten Messdaten ($M_p$, $M_{ref}$) der Probe (1) und Referenzprobe (6) mit Hilfe der Erregerspule (4) die gleiche magnetische Wechselfeldstärke (H) oder das gleiche magnetische Wechselfeld (B) sowohl in die Referenzprobe (6) als auch in die Probe (1) eingeprägt wird, und die Differenz der beiden erfassten Messdaten ($M_p$, $M_{ref}$) als Maß in die Gehaltsbestimmung für den magnetisierbaren und/oder nicht-magnetisierbaren Gehaltsanteil der Probe (1) eingeht.

2. Verfahren nach Anspruch 1, **dadurch gekennzeichnet, dass** die magnetischen Wechselfelder (B) über eine induktiv über das Joch (3, 30) mit der Erregerspule gekoppelte Messeinrichtung (5), insbesondere mit einer Messspule (13, 14), gemessen werden.

**3.** Verfahren nach Anspruch 1 oder 2, **dadurch gekennzeichnet, dass** bei der Gehaltsbestimmung des magnetisierbaren und/oder nicht-magnetisierbaren Gehaltsanteils in der Probe (1) die relative Permeabilität der Probe (1) und der Referenzprobe (6) bestimmt werden.

**4.** Verfahren nach einem der Ansprüche 1 bis 3, **dadurch gekennzeichnet, dass** die relative Permeabilität der Probe (1) als Summe der relativen Permeabilitäten von reinem Eisen und von Luft modelliert wird.

**5.** Verfahren nach einem der Ansprüche 1 bis 4, **dadurch gekennzeichnet, dass** die gleiche magnetische Wechselfeldstärke (H) durch Regelung des Spulenstroms i(t) der Erregerspule in Probe und Referenzprobe eingeprägt wird.

**6.** Verfahren nach einem der Ansprüche 1 bis 5, **dadurch gekennzeichnet, dass** das gleiche magnetische Wechselfeld (B) durch Regelung desselben in Probe (1) und Referenzprobe (6) eingeprägt wird.

**7.** Verfahren nach einem der Ansprüche 1 bis 6, **dadurch gekennzeichnet, dass** der Arbeitspunkt der Wechselfeldstärke (H) bei der Messdatenerfassung im Bereich des flachen Kurvenverlaufs der magnetischen Permeabilität des Jochs (3, 30) liegt.

**8.** Vorrichtung zur zerstörungsfreien Gehaltsbestimmung des magnetisierbaren und/oder nicht-magnetisierbaren Anteils einer Probe (1) mit einem ersten magnetisch leitenden Joch (3), das einen ersten Luftspalt (2) zur wahlweisen Aufnahme der Probe (1) oder einer Referenzprobe (6) aufweist, mit einer am Joch (3) vorgesehenen Erregerspule (4), mit einer mit dem ersten Joch (3) induktiv gekoppelten Messeinrichtung (5) und mit einer mit der Messeinrichtung (5) verbundenen Auswerteeinrichtung (15), die zur Gehaltsbestimmung für den magnetisierbaren und/oder nicht-magnetisierbaren Gehaltsanteil der Probe (1) ausgebildet ist, **dadurch gekennzeichnet, dass** die Vorrichtung eine mit dem Joch (3) induktiv gekoppelte erste Messspule (13) aufweist, von der die Messeinrichtung (5) Messdaten ($M_{ref}$, $M_p$) erfasst, und dass die Vorrichtung eine, mit der Erregerspule (4) zusammenwirkende Regeleinrichtung (7) zur Einprägung der gleichen magnetischen Wechselfeldstärke (H) oder des gleichen magnetischen Wechselfelds (B) im ersten Luftspalt (2) für die Referenzprobe (6) oder die Probe (1) aufweist, dass die Vorrichtung eine Differenzschaltung (19) aufweist, die zur Erzeugung von Differenzdaten ($M_{diff}$) aus den Messdaten ($M_{ref}$, $M_p$) von Referenzprobe (6) und Probe (1) ausgebildet ist, und dass die Vorrichtung eine mit einer mit der Differenzschaltung (19) verbundenen Auswerteeinrichtung (15) aufweist, die zur Gehaltsbestimmung für den magnetisierbaren und/oder nicht-magnetisierbaren Gehaltsanteil in der Probe (1) in Abhängigkeit der Differenzdaten ($M_{diff}$) ausgebildet ist.

**9.** Vorrichtung zur zerstörungsfreien Gehaltsbestimmung des magnetisierbaren und/oder nicht-magnetisierbaren Anteils einer Probe (1) mit einem ersten magnetisch leitenden Joch (3), das einen ersten Luftspalt (2) zur Aufnahme der Probe (1) aufweist, mit einer mit dem ersten Joch (3) induktiv gekoppelten erste Messspule (13), mit einem zweiten magnetisch leitenden Joch (30), das einen zweiten Luftspalt (12) zur Aufnahme einer Referenzprobe (6) aufweist, mit einer mit dem zweiten Joch (30) induktiv gekoppelten zweiten Messspule (14), mit einer Erregerspule (4), die mit den beiden Jochen (3, 30) induktiv gekoppelt ist, mit einer Messeinrichtung (5), die erste und zweite Messdaten von der ersten und zweiten Messspule (13, 14) erfasst, mit einer mit der Messeinrichtung (5) verbundenen Differenzschaltung (19), die zur Erzeugung von Differenzdaten ($M_{diff}$) aus den Messdaten ($M_{ref}$, $M_p$) von Referenzprobe (6) und Probe (1) ausgebildet ist, und mit einer mit der Differenzschaltung (19) verbundenen Auswerteeinrichtung (15), die zur Gehaltsbestimmung für den magnetisierbaren und/oder nicht-magnetisierbaren Gehaltsanteil in der Probe (1) in Abhängigkeit der Differenzdaten ($M_{diff}$) ausgebildet ist.

**10.** Vorrichtung zur zerstörungsfreien Gehaltsbestimmung des magnetisierbaren und/oder nicht-magnetisierbaren Anteils einer Probe (1) mit einem magnetisch leitenden Joch (3), das einen Mittelsteg (8) und zwei daran anschließende seitliche Schenkel (9, 10) mit je einem Luftspalt (2, 12) aufweist, wobei der erste Luftspalt (2) zum Einsetzen der Probe (1) und der zweite Luftspalt (12) zum Einsetzen der Referenzprobe (6) ausgebildet sind, mit mindestens einer am Mittelsteg (8) des Jochs (3) vorgesehenen Erregerspule (4) und mit wenigstens einer an jedem Schenkel (9, 10) vorgesehenen ersten und zweiten Messspule (13, 14), die mit dem Joch (3) induktiv gekoppelt sind, mit einer Messeinrichtung (5), die erste und zweite Messdaten ($M_p$, $M_{ref}$) von der ersten und zweiten Messspule (13, 14) erfasst, mit einer mit der Messeinrichtung (5) verbundenen Differenzschaltung (19), die zur Erzeugung von Differenzdaten ($M_{diff}$) aus den Messdaten ($M_p$, $M_{ref}$) von Referenzprobe (6) und Probe (1) ausgebildet ist, und mit einer mit der Differenzschaltung (19) verbundenen Auswerteeinrichtung (15), die zur Gehaltsbestimmung für den magnetisierbaren und/oder nicht-magnetisierbaren Gehaltsanteil in der Probe (1) in Abhängigkeit der Differenzdaten ($M_{diff}$) ausgebildet ist.

**11.** Vorrichtung nach Anspruch 9 oder 10, **dadurch gekennzeichnet, dass** die Differenzschaltung (19) zur Erzeugung von Differenzdaten ($M_{diff}$) beide Messspulen (13, 14) elektrisch in Serie schaltet.

*Fig. 1*

*Fig. 2*

Fig. 3

Fig. 4

Europäisches
Patentamt

European
Patent Office

Office européen
des brevets

# EUROPÄISCHER RECHERCHENBERICHT

Nummer der Anmeldung

EP 16 18 2466

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 3 337 795 A (MITITAKA YAMAMOTO ET AL) 22. August 1967 (1967-08-22) * Spalte 1, Zeile 29 - Spalte 2, Zeile 40; Abbildung 1 * ----- | 1-11 | INV. G01N27/72 G01R33/04 |
| X | US 2 755 433 A (LEASE CHARLES A ET AL) 17. Juli 1956 (1956-07-17) * Spalte 1, Zeile 23 - Spalte 2, Zeile 59 * ----- | 1-11 | |
| A | US 4 394 193 A (GFRERER MANFRED [DE]) 19. Juli 1983 (1983-07-19) * das ganze Dokument * ----- | 1-11 | |
| A,D | EP 0 267 896 A2 (VER EDELSTAHLWERKE AG [AT]) 18. Mai 1988 (1988-05-18) * das ganze Dokument * ----- | 1-11 | |

RECHERCHIERTE SACHGEBIETE (IPC)

G01N
G01R

Der vorliegende Recherchenbericht wurde für alle Patentansprüche erstellt

| Recherchenort | Abschlußdatum der Recherche | Prüfer |
|---|---|---|
| München | 19. Januar 2017 | Stussi, Elisa |

KATEGORIE DER GENANNTEN DOKUMENTE

X : von besonderer Bedeutung allein betrachtet
Y : von besonderer Bedeutung in Verbindung mit einer
   anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
   nach dem Anmeldedatum veröffentlicht worden ist
D : in der Anmeldung angeführtes Dokument
L : aus anderen Gründen angeführtes Dokument
...........................................................................................
& : Mitglied der gleichen Patentfamilie, übereinstimmendes
   Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 16 18 2466

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

19-01-2017

| Im Recherchenbericht angeführtes Patentdokument | Datum der Veröffentlichung | Mitglied(er) der Patentfamilie | Datum der Veröffentlichung |
|---|---|---|---|
| US 3337795 A | 22-08-1967 | KEINE | |
| US 2755433 A | 17-07-1956 | KEINE | |
| US 4394193 A | 19-07-1983 | DE 3015894 A1<br>EP 0039019 A1<br>JP S56168545 A<br>US 4394193 A | 29-10-1981<br>04-11-1981<br>24-12-1981<br>19-07-1983 |
| EP 0267896 A2 | 18-05-1988 | AT 390843 B<br>EP 0267896 A2<br>JP S63134947 A<br>US 4835471 A | 10-07-1990<br>18-05-1988<br>07-06-1988<br>30-05-1989 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0267896 A2